# EUROPEAN PATENT APPLICATION

(11) **EP 4 817 929 A1**
(43) Date of publication of application: **07.10.2026**
(21) Application number: 24896578.2
(22) Date of filing: 27.11.2024
(51) Int. Cl.: B60L 3/00, B60L 58/10, B60R 16/023

(54) **DETECTION DEVICE, VEHICLE, BATTERY MANAGER, AND LOOP CONTROL METHOD AND SYSTEM**

(30) Priority: 30.11.2023 CN 202311641208
(71) Applicant: BYD Company Limited, Shenzhen, Guangdong 518118 (CN)
(72) Inventor: LING, Heping, Shenzhen, Guangdong 518118 (CN); YAN, Lei, Shenzhen, Guangdong 518118 (CN); YIN, Deqian, Shenzhen, Guangdong 518118 (CN); YUAN, Shuai, Shenzhen, Guangdong 518118 (CN); WANG, Bing, Shenzhen, Guangdong 518118 (CN)
(74) Representative: Mathys & Squire
(86) International application number: PCT/CN2024/134929
(87) International publication number: WO 2025/113492

(57) **Abstract**

A high-voltage loop control system is provided, including a detection apparatus and a vehicle. The detection apparatus includes: a detection circuit, where the detection circuit is configured to connect to a charging port of the vehicle to form a detection loop, and the detection loop is adapted to trigger a vehicle to control disconnection of a high-voltage loop.

## Description

### CROSS-REFERENCES TO RELATED APPLICATIONS

The present disclosure claims priority to Chinese patent application No. 202311641208.7 filed with the China National Intellectual Property Administration on November 30, 2023 and entitled "DETECTION APPARATUS, VEHICLE, BATTERY MANAGEMENT CONTROLLER, AS WELL AS LOOP CONTROL METHOD AND SYSTEM", which is incorporated herein by reference in its entirety.

### TECHNICAL FIELD

The present disclosure relates to the field of vehicle technologies, and in particular, to a detection apparatus, a vehicle, a battery management controller, and a loop control method and system.

### BACKGROUND

Currently, high-voltage service and emergency disconnect solutions adopted by mainstream new energy vehicle manufacturers generally fall into two categories: a high-voltage service switch solution and a low-voltage service switch solution. The high-voltage service switch solution is generally used in commercial vehicles. The solution is to add a switch to a high-voltage loop to physically disconnect the high-voltage loop. The low-voltage service switch is generally used in passenger vehicles. In this solution, a battery management controller (BMC) or another controller collects the status of the low-voltage service switch, and performs a high-voltage disconnect operation when detecting that the low-voltage service switch is turned off. However, the two solutions have the following disadvantages:
(1) both solutions require additional costs, which is not conducive to the promotion of new energy vehicles.
(2) the high-voltage service switch solution is not applicable to the passenger vehicles due to constraints such as the battery pack structure of the passenger vehicles, and the waterproofing requirement of the entire vehicle.
(3) as switch positions involved in the two solutions vary with different vehicle enterprises and models, and the like, when a safety accident occurs in a new energy vehicle, it is inconvenient for firefighting, traffic police, and others to perform an emergency high-voltage disconnect operation.

### SUMMARY

The present disclosure is intended to solve one of technical problems in the related art at least to some extent. To this end, an objective of the present disclosure to provide a detection apparatus, a vehicle, a battery management controller, as well as a loop control method and system, thereby simply and conveniently causing a high-voltage loop of the vehicle to be in a disconnected state.

According to a first aspect, the present disclosure provides a detection apparatus, including: a detection circuit, wherein the detection circuit is configured to connect to a charging port of a vehicle to form a detection loop, and the detection loop is adapted to trigger the vehicle to control disconnection of a high-voltage loop.

In addition, a connector assembly according to the foregoing embodiment of the present disclosure may further have the following additional technical features:

According to one embodiment of the present disclosure, a first end of the detection circuit is configured to connect to a charging connection confirm terminal of the charging port, and a second end of the detection circuit is configured to connect to a vehicle body ground terminal of the charging port.

According to one embodiment of the present disclosure, the detection apparatus further includes: a first connector, connected to the first end of the detection circuit, and configured to establish a connection between the first end of the detection circuit and the charging connection confirm terminal.

According to one embodiment of the present disclosure, the detection apparatus further includes: a second connector, connected to the second end of the detection circuit, and configured to establish a connection between the second end of the detection circuit and the vehicle body ground terminal.

According to one embodiment of the present disclosure, the first connector includes a first plug, wherein when the charging port is provided with an alternating current charging inlet, the first plug is adapted to fit into a receptacle of the charging connection confirm terminal provided on the alternating current charging inlet; and when the charging port is provided with a direct current charging inlet, the first plug is adapted to fit into a receptacle of a second charging connection confirm terminal provided on the direct current charging inlet. The second charging connection confirm terminal is the charging connection confirm terminal connected to a vehicle control unit of the vehicle.

According to one embodiment of the present disclosure, the second connector includes a second plug, the second plug is adapted to fit into a receptacle of the vehicle body ground terminal provided on a charging inlet, wherein the charging port is provided with the charging inlet, and the charging inlet includes a direct current charging inlet, and/or an alternating current charging inlet.

According to one embodiment of the present disclosure, the detection circuit includes a first resistor, a first end of the first resistor is configured to connect to the charging connection confirm terminal, and a second end of the first resistor is configured to connect to the vehicle body ground terminal.

According to one embodiment of the present disclosure, the detection apparatus is adapted to be inserted into the charging port to form the detection loop.

According to one embodiment of the present disclosure, the detection apparatus is configured as a connector assembly, wherein the connector assembly is provided with a plug, and the plug is connected to the detection circuit and adapted to be inserted into the charging port.

According to one embodiment of the present disclosure, a resistance value of the detection circuit is different from a charging connection confirm resistance value required by a charging standard.

According to a second aspect, the present disclosure provides a high-voltage loop control method, including: when a charging port of a vehicle is connected to the detection circuit of the foregoing detection apparatus to form a detection loop, controlling a high-voltage loop of the vehicle to be in a disconnected state.

In addition, the high-voltage loop control method according to the foregoing embodiment of the present disclosure may further have the following additional technical features:

According to one embodiment of the present disclosure, the method further includes: when a vehicle speed of the vehicle is less than or equal to a vehicle speed threshold and the detection loop, controlling the high-voltage loop of the vehicle to be in a disconnected state.

According to one embodiment of the present disclosure, when the detection loop is formed, the method further includes: sending an alarm signal to a vehicle control unit of the vehicle, so that the vehicle control unit controls a high-voltage power-on indicator lamp of the vehicle to turn off and/or locks the vehicle in a parking gear.

According to one embodiment of the present disclosure, when the detection loop is formed, the method further includes: sending an alarm signal to an instrument panel and/or a vehicle-mounted terminal of the vehicle, so that the instrument panel and/or the vehicle-mounted terminal sends high-voltage power-off prompt information.

According to a third aspect, the present disclosure provides a battery management controller, including a memory, a processor, and a computer program that is stored in the memory. When the computer program is executed by the processor, the foregoing high-voltage loop control method is implemented.

According to a fourth aspect, the present disclosure provides a vehicle, including: a charging port, a high-voltage loop, and controller. The controller is connected to the high-voltage loop, and is configured to: when a charging port is connected to the detection circuit of the foregoing detection apparatus to form a detection loop, control the high-voltage loop to be in a disconnected state.

In addition, the vehicle according to the foregoing embodiment of the present disclosure may further have the following additional technical features:

According to one embodiment of the present disclosure, a first end of the detection circuit is configured to connect to a charging connection confirm terminal of the charging port, and a second end of the detection circuit is configured to connect to a vehicle body ground terminal of the charging port, wherein the controller is connected to the charging connection confirm terminal, and is configured to, based on a charging connection signal transmitted by the charging connection confirm terminal, determine whether the detection loop is formed.

According to one embodiment of the present disclosure, the charging connection signal is a voltage at a detection point corresponding to the charging connection confirm terminal, and the controller is configured to: when the voltage at the detection point is a first preset voltage, determine that the detection loop is formed, wherein when the charging port is connected to a charging connector, the voltage at the detection point is a second preset voltage value, and the second preset voltage is different from the first preset voltage.

According to one embodiment of the present disclosure, the first end of the detection circuit is configured to connect to a charging connection confirm terminal of the charging port, and a second end of the detection circuit is configured to connect to a vehicle body ground terminal of the charging port. The vehicle further includes: a vehicle-mounted electronic control unit, separately connected to the charging connection confirm terminal and the controller, and configured to: when it is determined, based on the charging connection signal transmitted by the charging connection confirm terminal, that the detection loop is formed, trigger the controller to control the high-voltage loop to be in a disconnected state.

According to one embodiment of the present disclosure, the high-voltage loop includes a battery pack, a switch circuit, and a high-voltage load, wherein the battery pack, the switch circuit, and the high-voltage load are connected in series, and the controller is connected to a control end of the switch circuit, and is configured to: when the detection loop is formed, control the switch circuit to be in a disconnected state.

According to one embodiment of the present disclosure, the switch circuit includes a positive switch and a negative switch, wherein the positive switch is connected between a positive electrode of the battery pack and the high-voltage load, and the negative switch is connected between a negative electrode of the battery pack and the high-voltage load. The controller is connected to a control end of the positive switch and/or a control end of the negative switch, and is configured to: when the detection loop is formed, control the positive switch and/or the negative switch to be in a disconnected state.

According to a fifth aspect, the present disclosure provides a high-voltage loop control system, including: the foregoing detection apparatus and the foregoing vehicle.

According to the detection apparatus, the vehicle, the battery management controller, as well as the loop control method and system provided by embodiments of the present disclosure, disconnection control of the high-voltage loop of the vehicle can be implemented simply and conveniently by using the detection apparatus.

Additional aspects and advantages of the present disclosure are set forth in part in the following description, and in part become apparent from the following description, or may be learned through the practice of the present disclosure.

### DESCRIPTION OF DRAWINGS

FIG. 1 is a block diagram of a structure of a detection apparatus according to one embodiment of the present disclosure;
FIG. 2(a) is a diagram of structure of a detection apparatus according to one embodiment of the present disclosure;
FIG. 2(b) is a block diagram of a structure of a detection apparatus according to another embodiment of the present disclosure; and
FIG. 3(a) is a diagram of a charging inlet according to one embodiment of the present disclosure;
FIG. 3(b) is a diagram of a charging connection interface according to one embodiment of the present disclosure;
FIG. 3(c) is a diagram of a control pilot circuit according to one embodiment of the present disclosure;
FIG. 3(d) is a diagram of a relationship between a connection state of an alternating current charging port and a resistance value of RC according to one embodiment of the present disclosure;
FIG. 4(a) is a diagram of a charging inlet according to another embodiment of the present disclosure;
FIG. 4(b) is a diagram of a charging connection interface according to another embodiment of the present disclosure;
FIG. 4(c) is a diagram of a control pilot circuit according to another embodiment of the present disclosure;
FIG. 4(d) is a diagram of parameters of a control pilot circuit according to another embodiment of the present disclosure;
FIG. 5 is a flowchart of a high-voltage loop control method according to one embodiment of the present disclosure;
FIG. 6 is an architectural diagram of a method for implementing high-voltage loop control according to one embodiment of the present disclosure;
FIG. 7 is an architectural diagram of a method for implementing high-voltage loop control according to another embodiment of the present disclosure;
FIG. 8 is a block diagram of a structure of a battery management controller according to one embodiment of the present disclosure;
FIG. 9 is a block diagram of a structure of a vehicle according to an embodiment of the present disclosure; and
FIG. 10 is a block diagram of a structure of a high-voltage loop control system according to an embodiment of the present disclosure.

### DETAILED DESCRIPTION OF EMBODIMENTS

Embodiments of the present disclosure are described in detail below, examples of which are shown in the accompanying drawings, where same or similar reference numerals throughout represent same or similar components or components having same or similar functions. The embodiments described below with reference to the accompanying drawings are exemplary and are intended to explain the present disclosure, and shall not be construed as a limitation on the present disclosure.

A connector assembly, a vehicle, as well as a high-voltage loop control method and system provided by embodiments of the present disclosure are described below with reference to accompanying drawings.

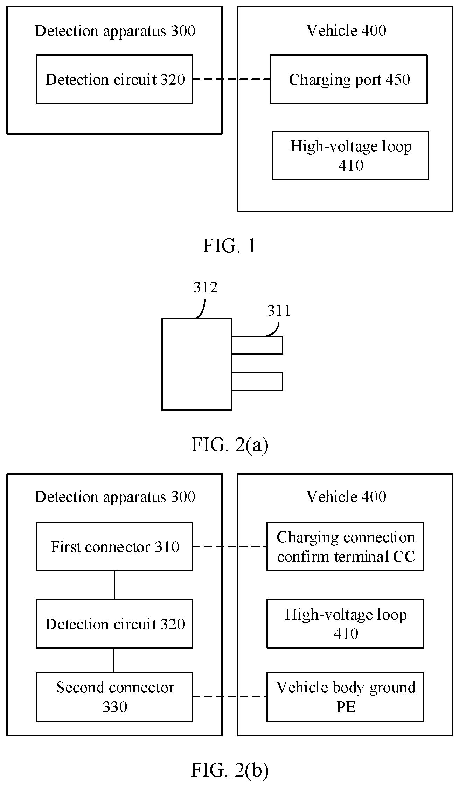

FIG. 1 is a block diagram of a structure of a detection apparatus according to one embodiment of the present disclosure.

As shown in FIG. 1, the detection apparatus 300 includes: a detection circuit 320.

With reference to FIG. 1, the detection circuit 320 is configured to connect to a charging port 450 of a vehicle 400 to form a detection loop, where the detection loop is adapted to trigger the vehicle 400 to control disconnection of a high-voltage loop.

Specifically, the charging port 450 may be provided with a plurality of connection terminals, such as a charging connection confirm terminal, a vehicle body ground terminal, and a control signal terminal. The detection circuit 320 may be connected to one or more of the connection terminals (for example, by using a wire or a specific connector) to form the detection loop. When the vehicle 400 detects that the detection loop is formed (for example, a specific resistance value, a specific voltage, or the like is detected), the high-voltage loop can be controlled to disconnect.

The detection apparatus 300 may be connected to the charging port 450 of the vehicle 400 in an emergency, so that emergency personnel can quickly disconnect the high-voltage loop 410 of the entire vehicle to avoid a safety accident. In addition, the detection apparatus 300, arranged independently of the vehicle 400, is applicable to various new energy vehicle models (including passenger vehicles and commercial vehicles) and can provide a wide range of applications.

According to some embodiments of the present disclosure, the detection apparatus 300 is adapted to be inserted into the charging port 450 to form the detection loop.

Specifically, the detection apparatus 300 may be provided with a structure such as a plug and a pin, and may be inserted into the charging port 450 by using the structure such as the plug and the pin, thereby forming the detection loop.

According to some examples, as shown in FIG. 2(a), the detection apparatus 300 may be configured as a connector assembly, where the connector assembly is provided with a plug 311, and the plug 311 is connected to the detection circuit 320 and adapted to be inserted into the charging port 450.

With reference to FIG. 2(a), the connector assembly further includes a body 312, and the detection circuit 320 may be provided in the body 312. The connector assembly may be provided with two plugs 311, where the two plugs 311 are provided on the body, are connected to both ends of the detection circuit 320, respectively, and are adapted to be inserted into receptacles of two connection terminals of the charging port 450. A shape and a size of the body 312, a position and a length of the plug 311, and the like may be determined based on a shape and a size of the charging port 450, positions and depths of the receptacles of the two corresponding connection terminals, and the like.

According to some embodiments of the present disclosure, a first end of the detection circuit 320 is configured to connect to a charging connection confirm terminal CC of the charging port, and a second end of the detection circuit 320 is configured to connect to a vehicle body ground terminal PE of the charging port.

When both ends of the detection circuit 320 are connected to the charging connection confirm terminal CC and the vehicle body ground terminal PE of the charging port, respectively, the detection loop may be formed.

Specifically, in some embodiments, as shown in FIG. 2(b), the detection apparatus 300 further includes a first connector 310, where the first connector 310 is connected to the first end of the detection circuit 320, and is configured to establish a connection between the first end of the detection circuit 320 and the charging connection confirm terminal.

After the first end of the detection circuit 320 is connected to the charging connection confirm terminal CC by using a first connector 310, and the second end of the detection circuit 320 is connected to the vehicle body ground terminal PE, the detection loop may be formed. In this case, the vehicle 400 may be triggered to control disconnection of the high-voltage loop 410, so that the high-voltage loop 410 is in a disconnected state (that is, when the high-voltage loop 410 is connected, it shall be disconnected; and when the high-voltage loop 410 is not connected, high-voltage power-on is prohibited to maintain the disconnected state).

Specifically, when it is necessary to urgently disconnect the high-voltage loop 410 of the vehicle 400, the detection circuit 320 of the detection apparatus 300 may be connected to the charging connection confirm terminal CC and the vehicle body ground terminal PE of the charging port 450 (for example, through receptacles of corresponding charging inlets). In a control pilot circuit of new energy vehicle charging standard (such as GB/T 18487.1 standard and GB/T 20234.3 standard), the charging connection confirm terminal CC is connected to the vehicle body ground terminal PE and/or a pull-up power supply of the vehicle 400 through a corresponding charging connection confirm resistor required by the standard, and the charging connection confirm terminal CC is provided with a detection point, where the detection point is connected to a vehicle control unit. During charging, the vehicle control unit may detect a connection status of the charging connection confirm terminal CC by using the detection point. Therefore, when the detection apparatus 300 is connected to the charging connection confirm terminal CC of the vehicle 400, the charging connection confirm terminal CC is further connected to the vehicle body ground terminal PE of the vehicle through the detection circuit 320. In this case, when a resistance value between the detection point and the vehicle body ground terminal PE, or a voltage signal at the detection point changes, the detection loop is formed. The vehicle 400 may determine, based on the resistance value or the voltage signal, whether the detection loop is formed. If the detection loop is formed, it indicates that there is a demand for emergency disconnection of the high-voltage loop 410 of the vehicle 400, that is, controlling the high-voltage loop 410 to be disconnected to ensure personal safety of the emergency personnel.

It will be noted that, to avoid false detection, that is, a connection of the detection apparatus 300 is mistakenly detected as a connection of a charging connector, a resistance value of the detection circuit 320 may be set to be different from a charging connection confirm resistance value required by the charging standard, so that a detection voltage for determining whether the detection loop is formed is different from that for determining whether the connection is the charging connection.

In some embodiments, as shown in FIG. 2(b), the detection apparatus 300 further includes: a second connector 330.

With reference to FIG. 2(b), the second connector 330 is connected to the second end of the detection circuit 320, and the second connector 330 is configured to establish a connection between the second end of the detection circuit 320 and the vehicle body ground terminal PE of the charging port 450. When the second connector 330 is connected to the vehicle body ground terminal PE, the second end of the detection circuit 320 may be grounded.

Specifically, during the use of the detection apparatus 300, the first connector 310 is connected to the charging connection confirm terminal CC of the vehicle 400 (for example, through a receptacle of a corresponding charging inlet), and the second connector 320 is connected to the vehicle body ground terminal PE of the vehicle 400 (for example, through a receptacle of a corresponding charging inlet). The vehicle 400 may determine, based on a voltage signal, whether a detection loop including the detection circuit 320 is formed. If the detection loop is formed, it indicates that there is a demand for emergency disconnection of the high-voltage loop 410 of the vehicle 400, that is, controlling the high-voltage loop 410 to be disconnected to ensure personal safety of the emergency personnel.

In some embodiments, the first connector 310 includes a first plug.

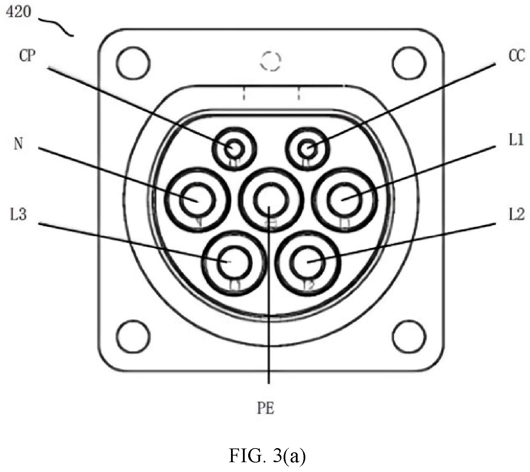

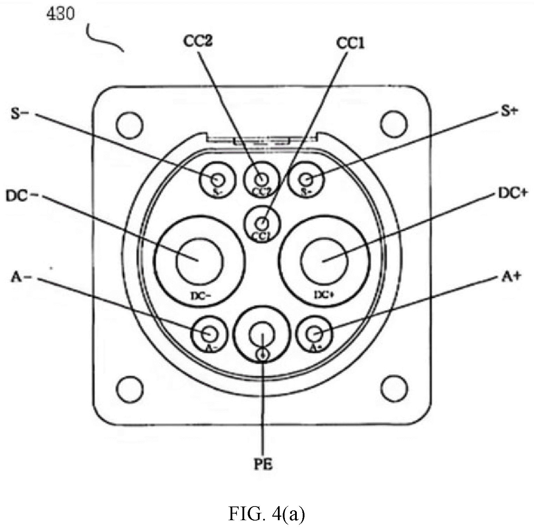

When the vehicle 400 is provided with an alternating current charging inlet 420 (as shown in FIG. 3(a)), the first plug is adapted to fit into a receptacle (as shown in FIG. 3(a)) of the charging connection confirm terminal CC provided on the alternating current charging inlet 420. When the vehicle 400 is provided with a direct current charging inlet 430 (as shown in FIG. 4(a)), the first plug is adapted to fit into a receptacle of a second charging connection confirm terminal CC2 provided on the direct current charging inlet 430 (as shown in FIG. 4(a)), where the second charging connection confirm terminal CC2 is a charging connection confirm terminal of a vehicle control unit connected to the vehicle 400.

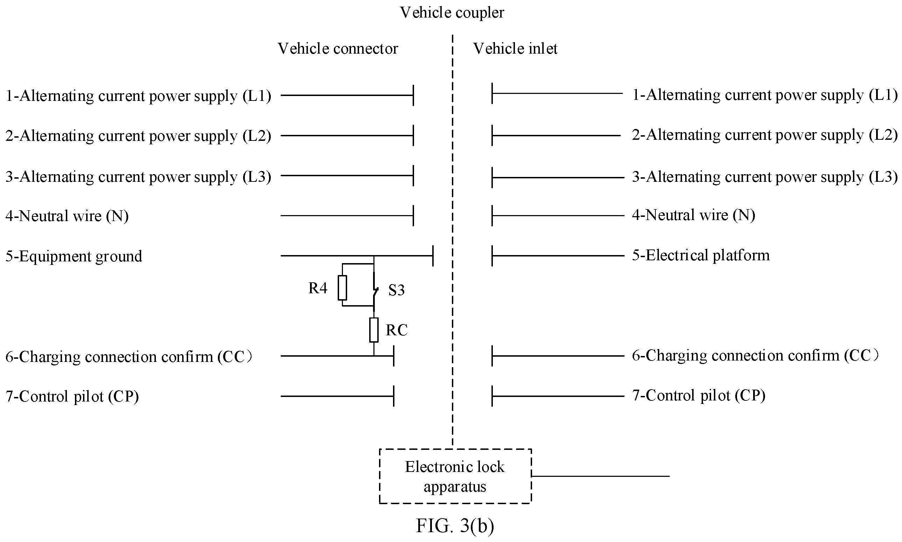

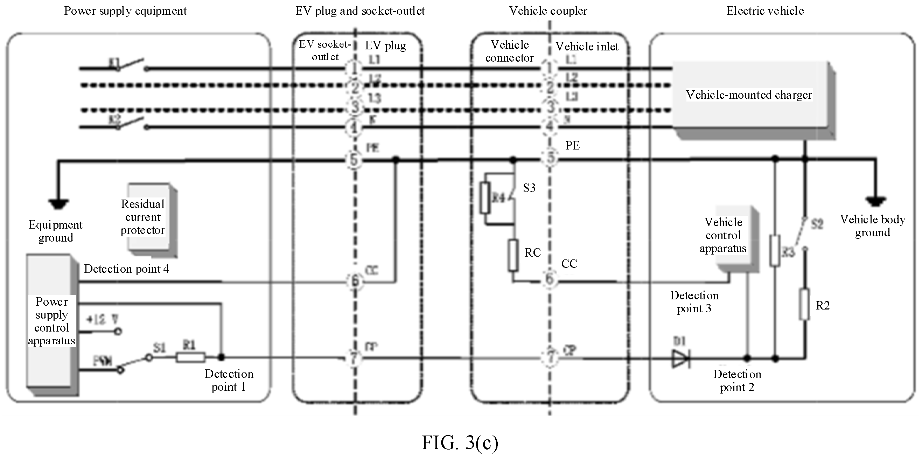

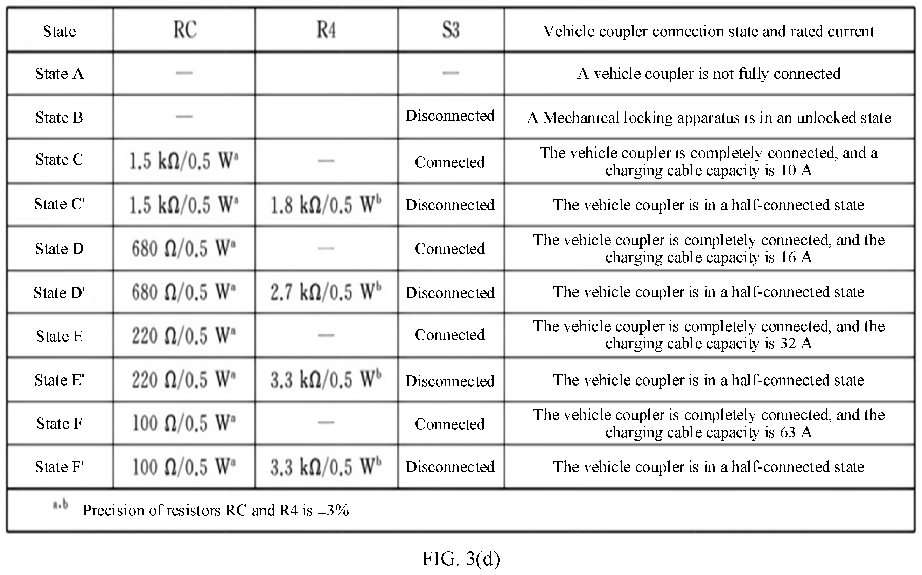

Specifically, in some examples, the vehicle 400 may perform alternating current charging according to the GB/T 18487.1 standard and the GB/T 20234.2 standard, where a charging connection interface of the vehicle 400 is shown in FIG. 3(b), a control pilot circuit is shown in FIG. 3(c), a connection status of the alternating current charging port and a resistance value of the RC are shown in FIG. 3(d), and the charging inlet 420 corresponding to the alternating current charging port is shown in FIG. 3(a). In this example, the first plug is adapted to fit into the receptacle of the charging connection confirm terminal CC provided on the alternating current charging inlet 420. During use, the first plug is simply inserted into the receptacle, and the operation is convenient. The charging connection confirm resistor includes resistors R4 and RC in FIG. 3(c). In this case, a resistance value of the detection circuit 320 may be 50 Ω.

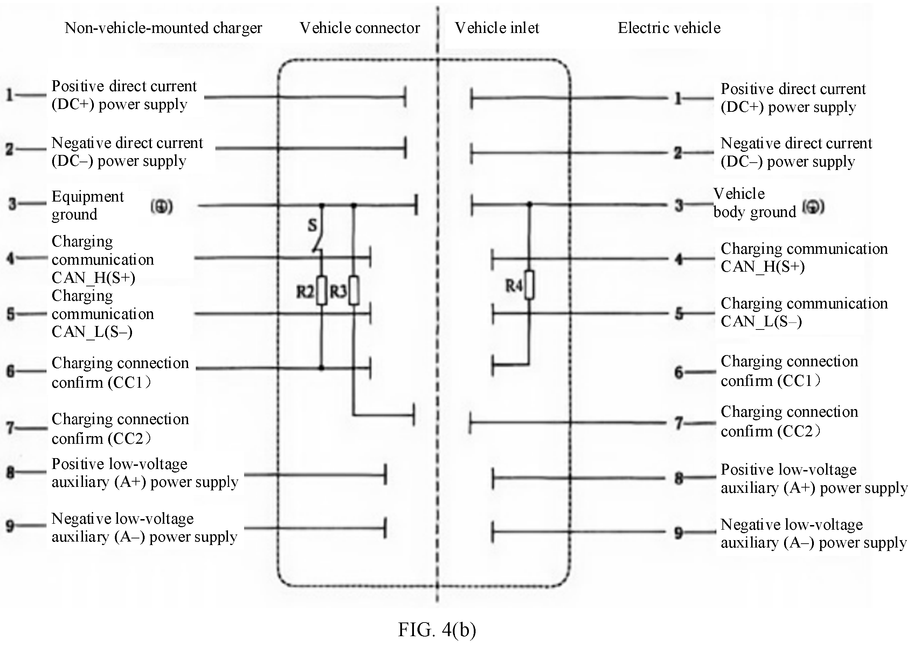

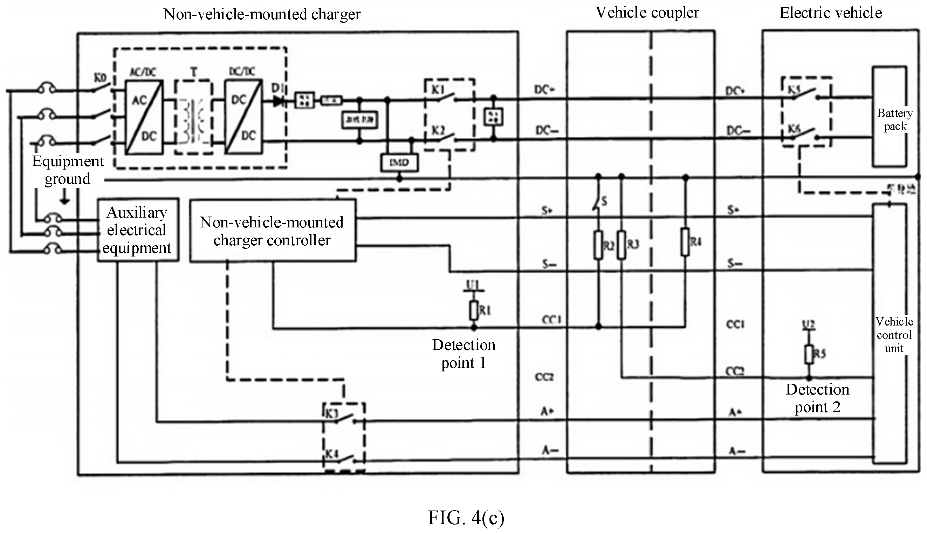

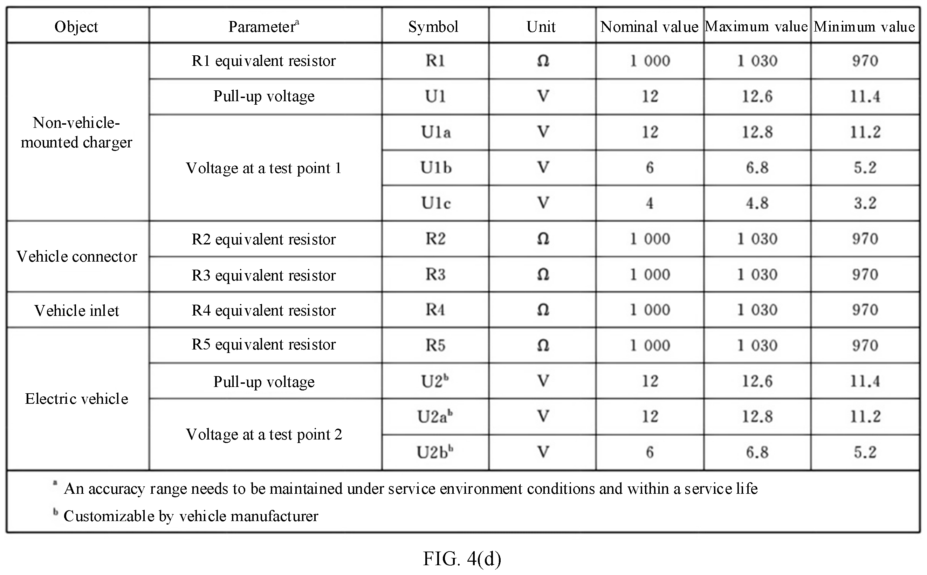

In some examples, the vehicle 400 may perform direct current charging according to the GB/T 18487.1 standard and the GB/T 20234.2 standard, where a charging connection interface of the vehicle 400 is shown in FIG. 4(b), a control pilot circuit is shown in FIG. 4(c), parameters of the control pilot circuit are shown in FIG. 4(d), and the charging inlet 430 corresponding to the direct current charging port is shown in FIG. 4(a). In this example, the first plug is adapted to fit into the receptacle of the second charging connection confirm terminal CC2 provided on the direct current charging inlet 430. During use, the first plug is simply inserted into the receptacle, and the operation is convenient. The charging connection confirm resistor includes resistors R3 and R5 in FIG. 4(c). In this case, a resistance value of the detection circuit 320 may be 500 Ω.

It will be noted that the vehicle 400 may be provided with merely the alternating current charging inlet 420, merely the direct current charging inlet 430, or both the alternating current charging inlet 420 and the direct current charging inlet 430. However, the foregoing detection apparatus 300 is applicable regardless of a charging mode.

In some embodiments, the vehicle 400 is provided with a charging inlet similar to the first connector 310, the second connector 330 includes a second plug, where the second plug is adapted to fit into a receptacle (as shown in FIG. 3(a) and FIG. 4(a)) of the vehicle body ground terminal PE provided on the charging inlet (such as the foregoing alternating current charging inlet 420, and the direct current charging inlet 430).

During actual use, for the alternating current charging port, there is no need to enter the vehicle, it is only necessary to open a cover of the alternating current charging inlet, insert the first plug into a receptacle of the corresponding CC, and insert the second plug into a receptacle of the corresponding PE, with convenient operation. Similarly, for the direct current charging port, there is no need to enter the vehicle, it is only necessary to open a cover of the direct current charging inlet, insert the second plug into a receptacle of the corresponding CC2, and insert the second plug into a receptacle of the corresponding PE, with convenient operation.

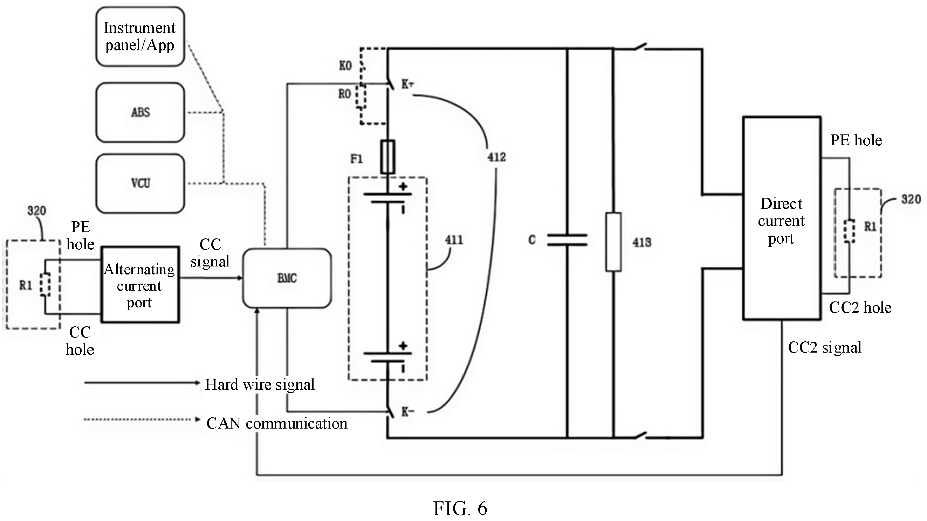

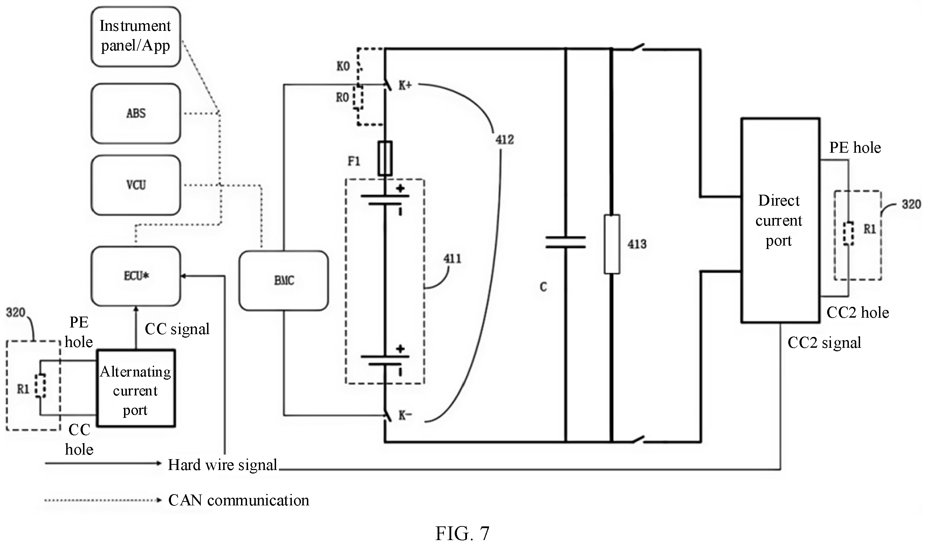

In some embodiments, as shown in FIG. 6 and FIG. 7, the detection circuit 320 includes a first resistor R1, a first end of the first resistor R1 is connected to the first connector 310, and a second end of the first resistor R1 is configured to connect to the vehicle body ground terminal PE.

A resistance value of the first resistor R1 is different from a charge connection confirm resistance value required by the charging standard.

In some embodiments, when the detection apparatus 300 is utilized to perform emergency disconnection of the high-voltage loop 410, to ensure safety of emergency personnel, a connection situation between the detection apparatus 300 and the vehicle 400 can be detected only when a vehicle speed of the vehicle 400 is less than or equal to a vehicle speed threshold, for example, 5 km/h.

The detection apparatus 300 provided by this embodiment of the present disclosure has the following advantages:
(1) There is no need to dispose a high-voltage service switch or low-voltage service switch on the new energy vehicle, thereby reducing cost of the entire vehicle.
(2) During use, the high-voltage loop 410 can be urgently controlled to be in a disconnected state by merely inserting the detection apparatus 300 into the vehicle 400 and detecting a specific resistance value corresponding to the charging connection confirm terminal CC through an existing apparatus (for example, a battery management controller BMC) on the vehicle 400. The whole process is simple and convenient to operate, can ensure the safety of maintenance, and meet a demand of quickly disconnecting the high-voltage loop in the case of emergency.
(3) Because both the alternating current and direct current charging ports are specified in national standards in China, the detection apparatus 300 provided by the present disclosure accesses a specific resistor to the charging connection confirm terminal CC to achieve a control function of disconnecting the high-voltage loop 410. This solution can be formulated as an industrial standard and can meet a special demand for firefighters, traffic police, and other personnel to quickly disconnect the high-voltage loop in emergency situations.

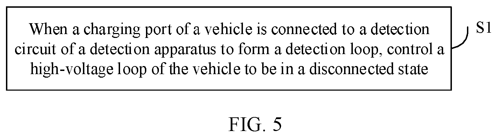

FIG. 5 is a flowchart of a high-voltage loop control method according to one embodiment of the present disclosure.

As shown in FIG. 5, the high-voltage loop control method includes the following steps.

S1: when a charging port of a vehicle is connected to a detection circuit of a detection apparatus to form a detection loop, control a high-voltage loop of the vehicle to be in a disconnected state.

The detection apparatus is the detection apparatus 300 in the foregoing embodiment.

Specifically, the high-voltage loop control method provided by the present disclosure may be executed by a battery management controller BMC of the vehicle. For example, as shown in FIG. 6, the BMC may be directly connected to a charging connection confirm terminal of the vehicle, thereby obtaining a CC signal from an alternating current port or a CC2 signal from a direct current port, where a formation status of the detection loop may be determined based on the CC signal or the CC2 signal. When the detection loop is formed, the high-voltage loop of the vehicle is controlled to be in a disconnected state. For another example, as shown in FIG. 7, the BMC is connected to a charging connection confirm terminal of the vehicle through a vehicle-mounted electronic control unit (ECU* in FIG. 7), and the vehicle-mounted electronic control unit may obtain a CC signal from an alternating current port or obtain a CC2 signal from a direct current port. That is, a resistance value or a voltage at the charging connection confirm terminal is obtained, and a formation status of the detection loop is determined based on the resistance value or the voltage. When the detection loop is formed, a trigger signal is sent to the BMC, and the BMC may determine, based on the trigger signal, that the detection loop is formed, and further control the high-voltage loop of the vehicle to be in a disconnected state. The BMC and the vehicle-mounted electronic control unit may be connected through a controller area network (CAN) bus.

According to the control method, the high-voltage loop of the vehicle is controlled to be in a disconnected state by connecting the detection apparatus to the charging port, with convenient operation and a wide range of application.

In some embodiments, before the high-voltage loop of the vehicle is controlled to be in the disconnected state, it is also required to determine that the vehicle speed is less than or equal to the vehicle speed threshold.

Specifically, as shown in FIG. 6 and FIG. 7, the BMC is further connected to a vehicle controller (VCU) of the vehicle (for example, connected via a CAN bus). Before controlling the high-voltage loop of the vehicle to be in the disconnected state, the BMC further obtains the vehicle speed of the vehicle from the VCU, and determines whether the vehicle speed is less than or equal to the vehicle speed threshold, for example, 5 km/h. When the vehicle speed (for example, 3 km/h) is less than the vehicle speed threshold, disconnection control of the high-voltage loop is performed. Safety of the personnel can be ensured by performing emergency high-voltage power-off control when the vehicle speed is low, and maintaining normal high-voltage power-on control when the vehicle speed is high. Certainly, it may also be determined that the vehicle speed is less than or equal to the vehicle speed threshold before the detection is formed by the detection loop.

In some embodiments, when the detection loop is formed, an alarm signal is sent to the vehicle control unit of the vehicle, so that the vehicle control unit controls a high-voltage power-on indicator lamp of the vehicle to turn off and/or locks the vehicle in a parking gear.

Specifically, when the detection loop is formed, the BMC sends an alarm signal (which may include discharge disallowance information) to the VCU, and the VCU may control, based on the alarm signal, the high-voltage power-on indicator lamp of the vehicle to turn off (that is, an indicator lamp corresponding to an OK gear), or lock the vehicle in a parking gear (P gear) to prevent the vehicle from traveling, thereby ensuring personnel safety and avoiding accidents.

In some embodiments, when the detection loop is formed, an alarm signal is sent to an instrument panel and/or a vehicle-mounted terminal of the vehicle, so that the instrument panel and/or the vehicle-mounted terminal sends high-voltage power-off prompt information.

Specifically, as shown in FIG. 6 and FIG. 7, the BMC is further connected (for example, connected via a CAN bus) to an instrument panel and a vehicle-mounted terminal of the vehicle. When the detection loop is connected, the BMC further sends an alarm signal to the instrument panel and/or the vehicle-mounted terminal of the vehicle, so that the instrument panel and/or the vehicle-mounted terminal (for example, an application APP installed by using the vehicle-mounted terminal) sends high-voltage power-off prompt information.

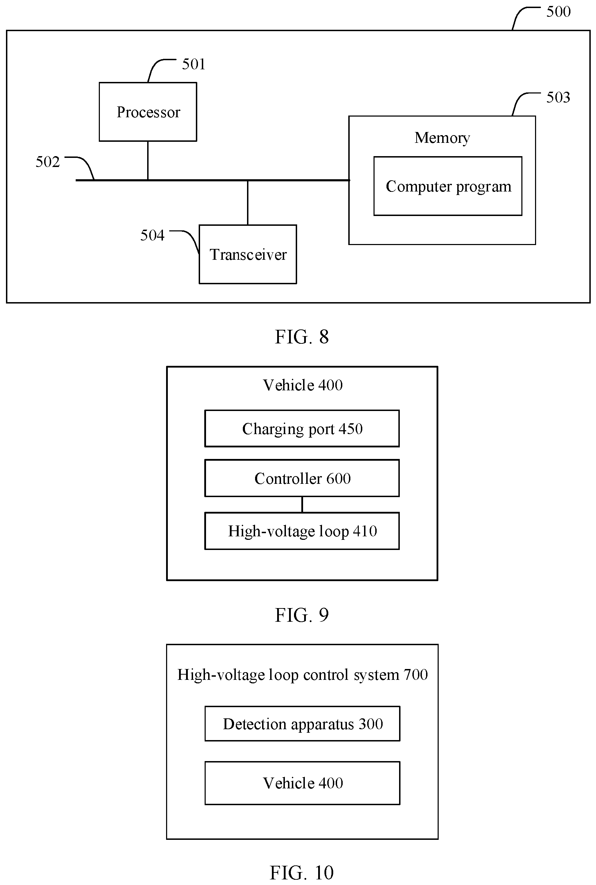

FIG. 8 is a block diagram of a structure of a battery management controller according to an embodiment of the present disclosure.

As shown in FIG. 8, the battery management controller 500 includes: a processor 501 and a memory 503. The processor 501 is connected to the memory 503, for example, via a bus 502. Optionally, the battery management controller 500 may further include a transceiver 504. It will be noted that in actual application, there is not limited to one transceiver 504, and a structure of the battery management controller 500 constitutes no limitation on this embodiment of the present disclosure.

The processor 501 may be a CPU (Central Processing Unit), a general-purpose processor, a DSP (Digital Signal Processor), an ASIC (Application Specific Integrated Circuit), an FPGA (Field Programmable Gate Array), or other programmable logic devices, a transistor logic device, a hardware device, or any combination thereof. It may implement or execute various exemplary logical blocks, modules, and circuits described in conjunction with the disclosure of the present disclosure. The processor 501 may be a combination capable of implementing a computing function, for example, including a combination of one or more microprocessors, or a combination of a DSP and a microprocessor.

The bus 502 may include a channel for communicating information among the foregoing components. The bus 502 may be a PCI (Peripheral Component Interconnect standard) bus, an EISA (Extended Industry Standard Architecture) bus, or the like. The bus 502 may be classified into an address bus, a data bus, a control bus, and the like. For ease of representation, the bus is represented by merely one thick line in FIG. 8, but this does not mean that there is merely one bus or merely one type of bus.

The memory 503 is configured to store a computer program corresponding to the high-voltage loop control method according to the foregoing embodiment of the present disclosure, and the computer program is controlled and executed by the processor 501. The processor 501 is configured to execute the computer program stored in the memory 503 to implement the content shown in the foregoing method embodiments. The battery management controller 500 shown in FIG. 8 is merely an example, and will not impose any limitation on functions and use scopes of embodiments of the present disclosure.

FIG. 9 is a block diagram of a structure of a vehicle according to an embodiment of the present disclosure.

As shown in FIG. 9, the vehicle 400 includes: a charging port 450, a high-voltage loop 410, and a controller 600.

The controller 600 is connected to the high-voltage loop 410, and is configured to: when the charging port 450 is connected to a detection circuit 320 of a detection apparatus 300 to form a detection loop, control the high-voltage loop 410 to be in a disconnected state.

According to some embodiments, a first end of the detection circuit 320 is configured to connect to a charging connection confirm terminal CC of the charging port 450, and a second end of the detection circuit 320 is configured to connect to a vehicle body ground terminal PE of the charging port 450.

In this embodiment, as shown in FIG. 6, the controller 600 (which may be the foregoing battery management controller 500, or reuse the vehicle control unit in each of FIG. 3(c) and FIG. 4(c), and is shown by BMC in FIG. 6) is connected to the charging connection confirm terminal CC, and configured to determine a formation status of the detection loop based on a charging connection signal transmitted by the charging connection confirm terminal CC (that is, the CC signal and the CC2 signal in FIG. 6, which may be voltages at corresponding detection points, such as a voltage at a detection point 3 in FIG. 3(c) and a voltage at a detection point 2 in FIG. 4(c)).

Specifically, the charging connection signal is a voltage at a detection point corresponding to the charging connection confirm terminal, and the controller 600 is configured to: when the voltage at the detection point is a first preset voltage, determine that the detection loop is formed, where when the charging port is connected to a charging connector, the voltage at the detection point is a second preset voltage value, and the second preset voltage is different from the first preset voltage.

It will be noted that the second preset voltage is different from the first preset voltage, this is because a resistance value of the detection circuit 320 is different from a charging connection confirm resistance value required by the charging standard.

In other embodiments, the vehicle 400 further includes a vehicle-mounted electronic control unit. As shown in FIG. 7, the vehicle-mounted electronic control unit (ECU in FIG. 7) is separately connected to a charging connection confirm terminal CC and a controller 600 (shown by BMC in FIG. 7), and is configured to determine a formation status of the detection loop based on a charging connection signal transmitted by the charging connection confirm terminal CC. In addition, when the detection loop is formed, the controller 600 is triggered to control the high-voltage loop 410 to be in a disconnected state, so that a power supply connection between a high-voltage load 413 and a battery pack 411 can be disconnected, thereby ensuring safety during emergency maintenance.

The vehicle-mounted electronic control unit may reuse an existing electronic control unit of the vehicle 400. In this embodiment, a detection function of the detection loop is provided in the vehicle-mounted electronic control unit, a control function of the high-voltage loop 410 is provided in the controller 600, and the vehicle-mounted electronic control unit can communicate with the controller 600 via a CAN bus, thereby transmitting a trigger signal that triggers the controller 600 to control the high-voltage loop 410 to be in a disconnected state. Compared with a solution that detection and control are performed merely by the controller 600 in FIG. 6, another detection and control solution is provided to increase diversity of the detection and control.

Optionally, the detection and control function may also be provided on both the controller 600 and the vehicle-mounted electronic control unit. In this case, the controller 600 may serve as a primary detection and control device, and the vehicle-mounted electronic control unit may serve as a backup detection and control device, thereby implementing redundancy, and improving reliability of detection and control.

In some embodiments, with reference to FIG. 6 and FIG. 7, the high-voltage loop 410 includes a battery pack 411, a switch circuit 412, and a high-voltage load 413. The battery pack 411, the switch circuit 412, and the high-voltage load 413 are connected in series.

The controller 600 is connected to a control end of the switch circuit 412, and is configured to: when a detection loop is formed, control the switch circuit 412 to be in a disconnected state. To ensure power supply stability of the high-voltage load 413, with reference to FIG. 6 and FIG. 7, the high-voltage loop 410 may further include a capacitor C, and the capacitor C is connected in parallel to the high-voltage load 413.

In some embodiments, the switch circuit 412 includes a positive switch K+ and/or a negative switch K- (in FIG. 6 and FIG. 7, including the positive switch K+ and the negative switch K- is shown as an example), the positive switch K+ is connected between a positive electrode of the battery pack 411 and the high-voltage load 413, and the negative switch K- is connected between a negative electrode of the battery pack 411 and the high-voltage load 413.

The controller 600 is connected to a control end of the positive switch K+ and/or a control end of the negative switch K- (FIG. 6 and FIG. 7, the connection with the control end of the positive switch K+ and the connection with the control end of the negative switch K- are shown as an examples) to control the positive switch K+ and/or the negative switch K- to be in a disconnected state when the detection loop is formed.

With reference to FIG. 6 and FIG. 7, the high-voltage loop 410 further includes a pre-charging circuit 414, and the pre-charging circuit 414 includes a pre-charging switch K0 and a pre-charging resistor R0, and the pre-charging switch K0 and the pre-charging resistor R0 are connected in series and then are connected in parallel to the positive switch K+. The pre-charging circuit 414 is configured to precharge when the high-voltage load 413 is powered on, thereby ensuring high-voltage power-on safety.

According to this embodiment of the present disclosure, the vehicle 400 is a rechargeable new energy vehicle, which may be provided with an alternating current charging inlet (which may also be referred to as an alternating current port) for alternating current charging, may be provided with a direct current charging inlet (which may also be referred to as a direct current port) for direct current charging, or may be provided with both the alternating current charging inlet and the direct current charging inlet for both alternating current charging and direct current charging.

In addition, with reference to FIG. 6 and FIG. 7, the vehicle 400 may further include an antilock brake system (ABS), the ABS may be connected to a CAN bus to communicate with a VCU, a BMC, and the like, thereby implementing related control of "antilock" during braking.

FIG. 10 is a block diagram of a structure of a high-voltage loop control system according to an embodiment of the present disclosure.

As shown in FIG. 10, the high-voltage loop control system 700 includes: the detection apparatus 300 according to the foregoing embodiment and the vehicle 400 according to the foregoing embodiment.

In conclusion, according to the detection apparatus, the vehicle, the battery management controller, as well as the high-voltage loop control method and system provided by embodiments of the present disclosure, disconnection control of a high-voltage loop of the vehicle can be implemented at a low cost, and the operation is simple and convenient, and the application range is wide.

It will be noted that logics and/or steps represented in the flowchart or described in other ways herein, for example, can be considered as a sequenced list of executable instructions for implementing a logical function, and can be specifically implemented in any computer-readable medium to be used by instruction execution systems, apparatuses, or devices (such as a computer-based system, a system including a processor, or other systems that can fetch instructions from instruction execution systems apparatuses, or devices and execute the instructions), or used in combination with these instruction execution systems, apparatuses, or devices. For this specification, the "computer-readable medium" may be any apparatus that may include, store, communicate with, propagate, or transmit a program to be used by the instruction execution systems, apparatuses, or devices or used in combination with these instruction execution systems, apparatuses, or devices. More specific examples (a non-exhaustive list) of the computer-readable medium include the followings: an electrical connection portion having one or more wires (an electronic apparatus), a portable computer cassette (a magnetic apparatus), a random access memory (RAM), a read-only memory (ROM), an erasable and programmable read-only memory (an EPROM or a flash memory), an optical fiber apparatus, and a portable compact disk read-only memory (CDROM). In addition, the computer-readable medium may even be paper or other suitable media on which the program can be printed because the program may be electronically obtained, for example, by optically scanning the paper or the other media and then editing, interpreting, or processing, when necessary, in other suitable ways, and is then stored in a computer memory.

It will be understood that various parts of the present disclosure may be implemented in hardware, software, firmware, or a combination thereof. In the foregoing implementations, a plurality of steps or methods may be implemented in software or firmware that is stored in a memory and that is executed by a suitable instruction execution system. For example, if implemented in hardware, as in another implementation, the plurality of steps or methods may be implemented by any one of the following technologies known in the art or a combination thereof: a discrete logic circuit having a logic gate circuit for implementing a logic function on a data signal, an application specific integrated circuit having a suitable combinational logic gate circuit, a programmable gate array (PGA), a field programmable gate array (FPGA), and the like.

In the description of the present disclosure, descriptions referring to the terms "one embodiment", "some embodiments", "examples", "specific examples" or "some examples" mean that specific features, structures, materials, or characteristics described in conjunction this embodiment or example are included in at least one embodiment or example of the present disclosure. In this specification, example expressions of the terms do not necessarily refer to a same embodiment or example. Moreover, specific features, structures, materials, or characteristics described may be combined in any suitable manner in any one or more embodiments or examples.

In the descriptions of the present disclosure, it will be understood that orientations or positional relationships indicated by the terms "center", "longitudinal", "transverse", "length", "width", "thickness", "upper", "lower", "front", "rear", "left", "right", "vertical", "horizontal", "top", "bottom", "inner", "outer", "clockwise", "counterclockwise", "axial", "radial", "circumferential", and the like are orientations or positional relationships as shown in the drawings, and are merely for the purpose of facilitating and simplifying the descriptions of the present disclosure instead of indicating or implying that apparatuses or elements indicated must have particular orientations, and be constructed and operated in the particular orientations, so that these terms are not construed as limiting the present disclosure.

Furthermore, terms "first" and "second" are used for descriptive purposes merely and will not be construed as indicating or implying the relative importance or implicitly indicating the number of the indicated technical features. Therefore, a feature limited by "first", "second", or the like may explicitly or implicitly include at least one of the features. In the description of the present disclosure, "a plurality of" means at least two, for example, two, three, or the like, unless otherwise expressly and specifically limited.

In the present disclosure, unless otherwise expressly specified and limited, the terms "mount", "couple", "connect", "fasten", or the like will be understood in a broad sense, such as, it may be a fixed connection, a detachable connection, or an integral connection; it may be a mechanical connection, or an electrical connection; or it may be a direct connection, an indirect connection through an intermediate medium, an internal connection of two elements, or interaction between two elements. For those of ordinary skill in the art, the specific meanings of the foregoing terms in the present disclosure can be understood according to specific situations.

In the present disclosure, unless otherwise expressly specified and limited, the first feature being "on" or "under" a second feature includes direct contact between the first feature and the second feature, as well as indirect contact between the first feature and the second feature through an intermediate member. In addition, the first feature being "above", "over", or "on" the second feature may be that the first feature is right above or obliquely above the second feature, or merely mean that a horizontal height of the first feature is higher than that of the second feature. The first feature being "below", "under", or "underneath" the second feature may be that the first feature is right below or obliquely below the second feature, or merely mean that a horizontal height of the first feature is lower than that of the second feature.

Although embodiments of the present disclosure have been shown and described above, it may be understood that embodiments described above are exemplary and will not be construed as a limitation of the present disclosure. Variations, modifications, substitutions, and variations of the foregoing embodiments may be made by those of ordinary skill in the art within the scope of the present disclosure.

## Claims

1. A detection apparatus (300), comprising:
a detection circuit (320), the detection circuit (320) being configured to connect to a charging port (450) of a vehicle (400) to form a detection loop, and the detection loop being adapted to trigger the vehicle (400) to control disconnection of a high-voltage loop (410).

2. The detection apparatus (300) according to claim 1, wherein a first end of the detection circuit (320) is configured to connect to a charging connection confirm terminal of the charging port (450), and a second end of the detection circuit (320) is configured to connect to a vehicle body ground terminal of the charging port (450).

3. The detection apparatus (300) according to claim 1 or 2, wherein the detection apparatus (300) further comprises:
a first connector (310), connected to the first end of the detection circuit (320), and configured to establish a connection between the first end of the detection circuit (320) and the charging connection confirm terminal.

4. The detection apparatus (300) according to claim 1 or 2, wherein the detection apparatus (300) further comprises:
a second connector (330), connected to the second end of the detection circuit (320), and configured to establish a connection between the second end of the detection circuit (320) and the vehicle body ground terminal.

5. The detection apparatus (300) according to claim 3, wherein the first connector (310) comprises a first plug, wherein
when the charging port (450) is provided with an alternating current charging inlet (420), the first plug is adapted to fit into a receptacle of the charging connection confirm terminal provided on the alternating current charging inlet (420); and
when the charging port (450) is provided with a direct current charging inlet (430), the first plug is adapted to fit into a receptacle of a second charging connection confirm terminal provided on the direct current charging inlet (430), wherein the second charging connection confirm terminal is a charging connection confirm terminal connected to a vehicle control unit of the vehicle (400).

6. The detection apparatus (300) according to claim 4, wherein the second connector (330) comprises a second plug, the second plug is adapted to fit into a receptacle of the vehicle body ground terminal provided on a charging inlet, wherein the charging port (450) is provided with the charging inlet, and the charging inlet comprises a direct current charging inlet (430) and/or an alternating current charging inlet (420).

7. The detection apparatus (300) according to claim 1 or 2, wherein the detection circuit (320) comprises a first resistor, a first end of the first resistor is configured to connect to the charging connection confirm terminal, and a second end of the first resistor is configured to connect to the vehicle body ground terminal.

8. The detection apparatus (300) according to claim 1 or 2, wherein the detection apparatus (300) is adapted to be inserted into the charging port (450) to form the detection loop.

9. The detection apparatus (300) according to claim 1 or 2, wherein the detection apparatus (300) is configured as a connector assembly, the connector assembly is provided with a plug (311), and the plug (311) is connected to the detection circuit (320) and adapted to be inserted into the charging port (450).

10. The detection apparatus (300) according to any one of claims 1 to 9, wherein a resistance value of the detection circuit (320) is different from a charging connection confirm resistance value required by a charging standard.

11. A high-voltage loop control method, comprising:
when a charging port (450) of a vehicle (400) is connected to a detection circuit (320) of the detection apparatus (300) according to any one of claims 1 to 10 to form a detection loop, controlling a high-voltage loop (410) of the vehicle (400) to be in a disconnected state.

12. The high-voltage loop control method according to claim 11, wherein the method further comprises:
when a vehicle speed of the vehicle (400) is less than or equal to a vehicle speed threshold, and the detection loop is formed, controlling the high-voltage loop (410) of the vehicle (400) to be in the disconnected state.

13. The high-voltage loop control method according to claim 11 or 12, wherein when the detection loop is formed, the method further comprises:
sending an alarm signal to a vehicle control unit of the vehicle (400), to enable the vehicle control unit to control a high-voltage power-on indicator of the vehicle (400) to turn off and/or lock the vehicle (400) in a parking gear.

14. The high-voltage loop control method according to claim 11 or 12, wherein when the detection loop is formed, the method further comprises:
sending an alarm signal to an instrument panel and/or a vehicle-mounted terminal of the vehicle (400), to enable the instrument panel and/or the vehicle-mounted terminal to send high-voltage power-off prompt information.

15. A battery management controller (500), comprising a memory (503), a processor (501), and a computer program stored in the memory (503), wherein when the computer program is executed by the processor (501), the high-voltage loop control method according to any one of claims 11 to 14 is implemented.

16. A vehicle (400), comprising a charging port (450), a high-voltage loop (410), and a controller (600); and
wherein the controller (600) is connected to the high-voltage loop (410), and is configured to: when the charging port (450) is connected to the detection circuit (320) of the detection apparatus (300) according to any one of claims 1 to 10 to form a detection loop, control the high-voltage loop (410) to be in a disconnected state.

17. The vehicle (400) according to claim 16, wherein a first end of the detection circuit (320) is configured to connect to a charging connection confirm terminal of the charging port (450), and a second end of the detection circuit (320) is configured to connect to a vehicle body ground terminal of the charging port (450); and
wherein the controller (600) is connected to the charging connection confirm terminal, and is configured to determine, based on a charging connection signal transmitted by the charging connection confirm terminal, whether the detection loop is formed.

18. The vehicle (400) according to claim 17, wherein the charging connection signal is a voltage at a detection point corresponding to the charging connection confirm terminal, and the controller (600) is configured to:
determine that the detection loop is formed when the voltage at the detection point is a first preset voltage; and
wherein when the charging port (450) is connected to a charging connector, the voltage at the detection point is a second preset voltage value, and the second preset voltage is different from the first preset voltage.

19. The vehicle (400) according to claim 16 or 17, wherein the first end of the detection circuit (320) is configured to connect to the charging connection confirm terminal of the charging port (450), the second end of the detection circuit (320) is configured to connect to the vehicle body ground terminal of the charging port (450), and the vehicle (400) further comprises:
a vehicle-mounted electronic control unit, separately connected to the charging connection confirm terminal and the controller (600), and configured to: when formation of the detection loop is determined based on the charging connection signal transmitted by the charging connection confirm terminal, trigger the controller (600) to control the high-voltage loop (410) to be in the disconnected state.

20. The vehicle (400) according to claim 16 or 19, wherein the high-voltage loop (410) comprises a battery pack (411), a switch circuit (412), and a high-voltage load (413), and the battery pack (411), the switch circuit (412), and the high-voltage load (413) are connected in series; and
wherein the controller (600) is connected to a control end of the switch circuit (412), and is configured to: when the detection loop is formed, control the switch circuit (412) to be in a disconnected state.

21. The vehicle (400) according to claim 20, wherein the switch circuit (412) comprises a positive switch and a negative switch, the positive switch is connected between a positive electrode of the battery pack (411) and the high-voltage load (413), and the negative switch is connected between a negative electrode of the battery pack (411) and the high-voltage load (413); and
the controller (600) is connected to a control end of the positive switch and/or a control end of the negative switch, and is configured to: when the detection loop is formed, control the positive switch and/or the negative switch to be in a disconnected state.

22. A high-voltage loop control system (700), comprising: the detection apparatus (300) according to any one of claims 1 to 10 and the vehicle (400) according to any one of claims 16 to 21.
